(19) Europäisches Patentamt
European Patent Office
Office européen des brevets

(11) **EP 2 533 245 B1**

(12) **FASCICULE DE BREVET EUROPEEN**

(45) Date de publication et mention
de la délivrance du brevet:
**18.03.2015 Bulletin 2015/12**

(51) Int Cl.:
***G11C 11/16*** *(2006.01)*

(21) Numéro de dépôt: **12170681.6**

(22) Date de dépôt: **04.06.2012**

(54) **Empilement magnétique et point mémoire comportant un tel empilement**

Magnetische Stapelung und mit einer solchen Stapelung ausgestatteter Speicherpunkt

Magnetic stack and memory point comprising such a stack

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **07.06.2011 FR 1154946**

(43) Date de publication de la demande:
**12.12.2012 Bulletin 2012/50**

(73) Titulaire: **COMMISSARIAT A L'ENERGIE ATOMIQUE ET AUX ENERGIES ALTERNATIVES 75015 Paris (FR)**

(72) Inventeurs:
• **Bandiera, Sébastien**
  **38700 La Tronche (FR)**
• **Rodmacq, Bernard**
  **38113 Veurey Voroize (FR)**

(74) Mandataire: **Lebkiri, Alexandre Cabinet Camus Lebkiri 25, Rue de Maubeuge 75009 Paris (FR)**

(56) Documents cités:
**WO-A2-03/043017**

**EP 2 533 245 B1**

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).

## Description

La présente invention concerne un empilement magnétique à aimantation hors du plan. On appelle « empilement magnétique à aimantation hors du plan » ou « empilement magnétique à aimantation perpendiculaire » un empilement magnétique qui présente une aimantation sensiblement perpendiculaire au plan suivant lequel s'étend l'empilement. L'invention concerne également une multicouche à aimantation hors du plan qui comporte un tel empilement magnétique, ainsi qu'un point mémoire comportant une telle multicouche et une mémoire magnétique à accès aléatoire comportant un tel point mémoire.

Les mémoires magnétiques à accès aléatoire ou mémoires MRAM («Magnetic Random Access Memory ») sont présentées comme une voie prometteuse pour obtenir des cellules mémoires performantes en termes de densité de stockage, de consommation et de fiabilité. Ces mémoires MRAMs comportent généralement des points mémoires qui comprennent :

- une couche magnétique appelée « couche de référence » qui présente une aimantation dont la direction est fixe ;
- une couche magnétique appelée « couche de stockage » qui présente une aimantation dont la direction est variable et qui peut s'orienter soit parallèlement, soit antiparallèlement à la direction d'aimantation de la couche de référence ;
- une barrière tunnel qui sépare la couche de référence et la couche de stockage.

Le document FR2817999 décrit par exemple un tel point mémoire.

Chaque point mémoire présente généralement deux modes de fonctionnement : un mode « lecture » et un mode « écriture ». Lors du mode écriture, un courant d'électrons est envoyé à travers les couches ou un champ magnétique est appliqué sur la couche de stockage du point mémoire, de façon à provoquer le retournement de la direction d'aimantation de la couche de stockage, qui devient alors parallèle ou antiparallèle à la direction d'aimantation de la couche de référence. Suivant que la direction d'aimantation de la couche de stockage est parallèle ou antiparallèle à la direction d'aimantation de la couche de référence, un « 1 » ou un « 0 » est stocké dans la couche de stockage.

Lors du mode lecture, un courant d'électrons est injecté à travers le point mémoire de façon à lire sa résistance. Lorsque les directions d'aimantation de la couche de référence et de la couche de stockage sont parallèles, la résistance du point mémoire est faible, tandis que lorsque les directions d'aimantation des couches de référence et de stockage sont antiparallèles, la résistance du point mémoire est élevée. Par comparaison avec une résistance de référence, la valeur stockée dans la couche de stockage (« 0 » ou « 1 ») peut être déterminée.

Généralement, les couches de référence et de stockage présentent des directions d'aimantation qui sont parallèles au plan de chacune de ces couches. On parle alors de couches magnétiques à aimantation dans le plan ou à aimantation planaire.

Cependant, les premières générations de mémoires MRAM, basées sur des points mémoires à aimantation planaire et à commutation par champ magnétique, sont loin de pouvoir concurrencer les mémoires de type flash car la densité de stockage disponible est encore trop faible. Or, la réduction de la taille des points mémoires est limitée dans ces mémoires MRAMs par la densité de courant que peut supporter la ligne de champ et par le critère de stabilité de rétention d'information sur des longues périodes, par exemple pendant 10 ans, qui impose un volume magnétique minimum pour ne pas perdre l'information par activation thermique.

Pour remédier à ce problème, des points mémoires comportant des couches à aimantation hors du plan ont été développées. Dans ce document, on appelle « couche ou multicouche à aimantation hors du plan », une couche ou une multicouche qui présente une aimantation qui est perpendiculaire au plan de la couche ou de la multicouche. Par extension, on appelle « point mémoire à aimantation hors du plan » un point mémoire qui comporte une telle couche.

Les points mémoires à aimantation hors du plan peuvent présenter des dimensions beaucoup plus faibles que les points mémoires à aimantation dans le plan tout en conservant une stabilité satisfaisante. En outre, elles peuvent être écrites par courant polarisé en spin.

Il est donc d'une importance capitale de pouvoir fabriquer des matériaux à aimantation hors du plan qui possèdent une anisotropie la plus forte possible de façon à pouvoir diminuer la taille du point mémoire, et avec une épaisseur magnétique minimale de façon à diminuer le courant critique de commutation par transfert de spin.

De nombreux matériaux à aimantation perpendiculaire ont été développés dans le passé pour les applications de stockage de l'information comme par exemple les alliages terre rare/métal magnétique de transition. La publication de X. Liu, A. Morisako, H. Sakurai, Y. Sakurai, M. Itou, and A. Koizumi, "Perpendicular magnetic anisotropy in sputtered amorphous TbFeCo films", J. Magn. Magn. Mater. 310, 1744-1746 (2007) décrit de tels matériaux à aimantation hors du plan.

On connaît également des matériaux granulaires comme les alliages Cobalt-Chrome-Platine qui présentent une aimantation hors du plan. Ces matériaux sont par exemple décrit dans la publication de D. Watanabe, S. Mizukami, F. Wu, M. Oogane, H. Naganuma, Y. Ando, and T. Miyazaki, "Interlayer exchange coupling in perpendicularly magnetized synthetic ferrimagnet structure using CoCrPt and CoFeB", Journal of Physics: Conference Series 200, 072104 (2010).

On connaît également les alliages ordonnés $L1_0$ de type FePt, CoPt, FePd, CoPd, etc....qui présentent une aimantation hors du plan. Ces matériaux sont par exemple décrit dans la publication de F. Casoli, F. Albertini, L. Pareti, S. Fabbrici, L. Nasi, C. Bocchi, and R. Ciprian, "Growth and Characterization of Epitaxial Fe-Pt Films", IEEE Trans. Magn. 41, 3223-3225 (2007) ou dans la publication de M. Yoshikawa, E. Kitagawa, T. Nagase, T. Daibou, M. Nagamine, K. Nishiyama, T. Kishi, and H. Yoda, "Tunnel Magnetoresistance Over 100% in MgO-Based Magnetic Tunnel Junction Films With Perpendicular Magnetic L10-FePt Electrodes", IEEE Trans. Magn. 44, 2573-2576 (2008), ou encore dans la publication de K. Barmak, J. Kim, L.H. Lewis, K.R. Coffey, A.J. Kellock, and J.-U. Thiele, "On the relationship of magnetocrystalline anisotropy and stoichiometry in epitaxial L10 CoPt (001) and FePt (001) thin films", J. Appl. Phys 98, 033904 (2005).

Un autre exemple de matériaux à aimantation hors du plan est également décrit dans la publication de L. E. Nistor, B. Rodmacq, S. Auffret, and B. Dieny "Ptl-Co/oxide and oxidelCoIPt electrodes for perpendicular magnetic tunnel junctions", Appl. Phys. Lett. 94, 012512 (2009).

Les publications de F.J.A. den Broeder, W. Hoving, and P.J.H. Bloemen, "Magnetic anisotropy of multilayers", J. Magn. Magn. Mater. 93, 562-570 (1991) et de M.T. Johnson, P.J.H. Bloemen, F.J.A. den Broeder, and J.J. de Vries, "Magnetic anisotropy in metallic multilayers", Rep. Prog. Phys. 59, 1409-1458 (1996) décrivent également des empilements à aimantations hors du plan. Ces empilements sont le plus souvent constitués de répétitions d'une première couche de métal non magnétique, par exemple en platine ou en palladium, sur laquelle est déposée une deuxième couche en métal magnétique, par exemple en cobalt ou alliage à base de Co, Ni et Fe.

Toutefois, ces empilements ne peuvent pas être utilisés seuls dans des points mémoires. En effet, pour que ces empilements présentent une aimantation hors du plan significative, ils doivent présenter une épaisseur inférieure à 1 nm. Au contraire, pour obtenir un point mémoire présentant une magnétorésistance tunnel optimale, il est nécessaire d'avoir des multicouches qui présentent une épaisseur magnétique d'au moins 1.5 nm en contact avec la barrière tunnel. On peut ainsi obtenir une magnétorésistance d'au moins 100% dans le cas de barrière de MgO. Une solution pour remédier à ce problème est de déposer une couche additionnelle d'épaisseur suffisante pour assurer une grande amplitude de magnétorésistance (c'est-à-dire au moins 60%) sur l'empilement à aimantation hors du plan. Par couplage d'échange à travers l'interface entre cette couche additionnelle et la couche à aimantation hors du plan, l'aimantation de la couche additionnelle sera tirée hors du plan si l'anisotropie perpendiculaire de l'empilement est suffisante. Dans le cas d'un fort couplage et en supposant que l'anisotropie de la couche additionnelle est uniquement due à l'effet de forme, le critère pour obtenir l'anisotropie perpendiculaire est :

$$K^{eff}_1 t_1 > K^{eff}_2 t_2 = 2\pi t_2 Ms_2^2 \ (1),$$

avec $K^{eff}_1$ l'anisotropie effective par unité de volume de l'empilement à aimantation perpendiculaire prenant en compte à la fois l'anisotropie perpendiculaire qui tire l'aimantation de cette couche hors du plan et son anisotropie de forme qui tend à rabattre son aimantation dans le plan,

$t_1$ l'épaisseur magnétique de l'empilement à aimantation perpendiculaire, $Ms_2$ l'aimantation de la couche additionnelle

et $t_2$ l'épaisseur de la couche additionnelle.

$2\pi t_2 Ms_2^2$ est le terme d'anisotropie de forme due au champ démagnétisant dans une couche mince magnétique.

Le critère de stabilité d'un point mémoire s'écrit alors $S^*(K^{eff}_1 t_1 - 2\pi t_2 Ms_2^2) > 50 k_B T$, S étant la section du point mémoire. Pour un point mémoire cylindrique, on obtient un diamètre minimal valant :

$$d_{min} = \sqrt{\frac{200 k_B T}{\pi (K^{eff}_1 t_1 - 2\pi_2 Ms_2^2)}} \ (2)$$

Afin d'obtenir un diamètre minimal $d_{min}$ le plus faible possible, il convient de maximiser le dénominateur de l'équation (2). Ceci peut se faire soit en augmentant l'épaisseur totale de l'empilement $t_1$, ce qui n'est pas souhaitable pour l'écriture par transfert de spin car cela conduit à augmenter la densité de courant nécessaire à la commutation de l'aimantation de cette couche par transfert de spin, soit en maximisant l'anisotropie effective de l'empilement à anisotropie perpendiculaire $K^{eff}_1$.

Il est donc particulièrement avantageux d'avoir un empilement magnétique à aimantation hors du plan qui présente l'anisotropie effective $K^{eff}_1$ la plus forte possible.

L'invention vise donc à proposer un empilement magnétique à aimantation hors du plan qui présente l'anisotropie effective la plus forte possible. Pour ce faire, l'invention propose d'insérer une couche en cuivre, en magnésium ou en tout matériau présentant une faible miscibilité avec le matériau magnétique entre la première couche en métal non magnétique et la deuxième couche en métal magnétique.

Plus précisément, l'invention concerne un empilement magnétique à aimantation hors du plan, l'empilement comportant :

- une première couche magnétique constituée d'un ou plusieurs matériaux pris dans le groupe suivant : cobalt, fer et nickel et les alliages magnétiques à base de ces matériaux ;
- une deuxième couche constituée d'un matériau métallique apte à conférer à un ensemble formé par la première et la deuxième couches une anisotropie perpendiculaire d'origine interfaciale quand la deuxième couche présente une interface commune avec la première couche,

l'empilement comportant en outre, une troisième couche déposée sur la première couche, la deuxième couche étant déposée sur la troisième couche, la troisième couche étant constituée d'un matériau métallique présentant une miscibilité inférieure à 10% avec le matériau de la première couche.

La miscibilité désigne usuellement la capacité de divers matériaux à se mélanger. En effet, dans les alliages binaires comprenant deux composantes A et B, la miscibilité de B dans A traduit la capacité du matériau B à se diluer de façon homogène dans le matériau A. Si le matériau B a une faible capacité à se diluer de façon homogène dans le matériau A, on dit qu'il a une faible miscibilité dans A ou une faible solubilité dans A. Cette capacité d'un matériau à se diluer de façon homogène dans un autre est reflétée de façon connue par le diagramme de phase de l'alliage binaire A-B.

L'empilement magnétique présente une direction d'aimantation hors du plan à température ambiante.

De manière étonnante, le fait d'ajouter entre la première couche en métal magnétique et la deuxième couche en métal non magnétique une troisième couche dans un matériau métallique présentant une faible miscibilité avec le matériau de la première couche, permet d'augmenter l'anisotropie hors du plan de l'empilement. Lorsque l'épaisseur de cette troisième couche est optimisée, typiquement de l'ordre de un à quelques plans atomiques, l'empilement présente alors une anisotropie hors du plan supérieure à celle qu'il présenterait en l'absence de la troisième couche.

Les matériaux utilisés pour réaliser la troisième couche sont des matériaux qui ne se mélangent pas ou mal avec les matériaux qui constituent la première couche. En d'autres termes, la troisième couche est réalisée dans un matériau qui ne diffuse pas ou pratiquement pas dans le matériau dans lequel est réalisée la première couche.

Comme dit précédemment, la présence de la troisième couche permet d'augmenter l'anisotropie hors du plan de l'empilement lorsqu'elle est déposée directement sur la première couche et que la deuxième couche est elle-même déposée directement sur la troisième couche. Par contre, si on fait l'inverse, c'est-à-dire que l'on dépose la troisième couche sur la deuxième couche, puis qu'on dépose la première couche sur la troisième couche, l'anisotropie hors du plan de l'empilement n'est pas augmentée mais au contraire diminuée.

Par ailleurs, l'empilement selon l'invention est particulièrement avantageux en ce qu'il conserve une bonne anisotropie hors du plan même après un recuit entre 250°C et 350°C.

Par ailleurs, le fait d'ajouter la troisième couche entre la première et la deuxième couche permet à l'empilement de présenter une température de Curie réduite par rapport à celle qu'il présenterait s'il ne comportait pas la troisième couche tout en conservant une aimantation hors du plan.

L'empilement peut également présenter une ou plusieurs des caractéristiques ci-après, prises individuellement ou selon toutes les combinaisons techniquement possibles.

La deuxième couche est de préférence constituée d'un ou plusieurs matériaux pris dans le groupe suivant : platine, palladium, or, iridium, molybdène.

La troisième couche est de préférence constituée d'un matériau pris dans le groupe suivant : cuivre, argent, magnésium, aluminium. Ces matériaux présentent une miscibilité inférieure à 10% avec le matériau de la première couche.

Selon un mode de réalisation non limitatif, la troisième couche présente une épaisseur comprise entre 0.2 et 1.5 nm. En effet, en dessous de 0.2nm, la première couche n'est pas entièrement recouverte par la troisième couche. Par ailleurs, le fait d'augmenter l'épaisseur de la troisième couche au-delà de 1.5 nm ne permet pas d'augmenter l'anisotropie hors du plan de l'empilement. Il est donc inutile de déposer une troisième couche plus épaisse que 1.5nm.

Selon un mode de réalisation non limitatif, la première couche est une couche de cobalt qui présente une épaisseur inférieure à 0.3 nm, de préférence strictement inférieure à 0.3 nm. Ainsi, l'empilement présente une température de Curie de l'ordre de 150°C, ce qui permet de faire basculer facilement l'aimantation de l'empilement à l'aide de la température pour la faire passer d'une aimantation hors du plan à une aimantation dans le plan.

Selon un mode de réalisation non limitatif, la première couche présente une épaisseur inférieure ou égale à 2 nm. En effet, au-delà de 2 nm, le fait d'insérer la troisième couche entre la première et la deuxième couche ne permet plus d'augmenter de manière significative l'anisotropie hors du plan de l'empilement.

Selon un mode de réalisation non limitatif, la première et la deuxième couche présentent chacune une épaisseur supérieure à 0.2nm. En effet, en dessous de 0.2nm, ces couches ne permettant pas de couvrir entièrement les couches sur lesquelles elles sont déposées.

Un mode de réalisation de l'invention concerne une multicouche comportant au moins un premier et un deuxième empilement selon le premier aspect de l'invention, la multicouche présentant une aimantation hors du plan, la première couche du deuxième empilement étant déposée sur la deuxième couche du premier empilement.

La multicouche présente une direction d'aimantation hors du plan à température ambiante.

En effet, pour avoir une multicouche qui présente une anisotropie hors du plan la plus importante possible, dans chaque empilement, la troisième couche doit être déposée sur la première couche et la deuxième couche doit être déposée sur la troisième couche. Par contre, la première couche du deuxième empilement doit être déposée directement sur la deuxième couche du premier empilement.

Le fait d'empiler plusieurs empilements selon le premier aspect de l'invention permet de former une multicouche présentant une anisotropie hors du plan d'épaisseur supérieure à 1 nm.

La multicouche peut également présenter une ou plusieurs des caractéristiques ci-après, prises individuellement ou selon toutes les combinaisons techniquement possibles.

Selon un mode de réalisation non limitatif, la multicouche comporte en outre une couche additionnelle en matériau magnétique déposée sur les empilements. Le fait de déposer une couche additionnelle sur les empilements permet d'augmenter l'épaisseur magnétique, tout en conservant une anisotropie hors du plan pour la multicouche. En effet, les empilements de la multicouche présentent une anisotropie hors du plan très importante de sorte qu'ils permettent de « tirer » l'aimantation de la couche additionnelle hors du plan par couplage magnétique à travers l'interface entre la couche additionnelle et les empilements de la multicouche. Pour cela, il faut que l'énergie d'anisotropie totale des empilements de la multicouche soit supérieure à celle de la couche additionnelle de façon à ce que ce soient les empilements qui tirent l'aimantation de la couche additionnelle hors du plan et non pas l'inverse c'est-à-dire que l'aimantation planaire de la couche additionnelle ne tire pas l'aimantation de la multicouche dans le plan.

Selon un mode de réalisation non limitatif, la couche additionnelle est réalisée dans un des matériaux suivants : cobalt, fer, nickel ou alliages à base de ces matériaux.

La couche additionnelle peut également comporter un ou plusieurs des éléments suivants : B, V, Cr, Zr, Hf, Pt, Pd.

Selon un mode de réalisation non limitatif, particulièrement intéressant dans le cadre des applications mémoires de type MRAM, la multicouche présente une épaisseur comprise entre 0.5 nm et 4 nm. En effet, la multicouche doit de préférence présenter une épaisseur inférieure à 4 nm de façon à garder une épaisseur magnétique modérée de sorte à pouvoir être retournée par transfert de spin avec des densités de courant supportable par une barrière tunnel c'est-à-dire typiquement inférieure à $2.10^7 A/cm^2$. En outre, le fait d'avoir une épaisseur supérieure à 0.5 nm permet d'utiliser la multicouche comme couche de référence ou comme couche de stockage dans un point mémoire.

Un mode de réalisation de l'invention concerne également un point mémoire comportant :

- une première multicouche magnétique dite « couche de référence » ;
- une deuxième multicouche magnétique dite «couche de stockage», la couche de stockage présentant une direction d'aimantation variable ;
- un espaceur qui sépare la couche de référence et la couche de stockage ; la couche de référence et/ou la couche de stockage comportant une multicouche selon le deuxième aspect de l'invention.

Le point mémoire ainsi réalisé est particulièrement avantageux car il peut présenter des dimensions latérales très petites, c'est-à-dire typiquement inférieures à 45 nm, tout en présentant une bonne stabilité thermique.

Un mode de réalisation de l'invention concerne une mémoire magnétique à accès aléatoire comportant un point mémoire selon le troisième aspect de l'invention.

D'autres caractéristiques et avantages de l'invention ressortiront à la lecture de la description qui suit, en référence aux figures annexées, qui illustrent :

- la figure 1a, une vue en coupe d'un empilement selon un mode de réalisation de l'invention ;
- la figure 1b, un diagramme de phase de l'alliage binaire Co-Cu ;
- la figure 2, une vue en coupe d'une multicouche selon un mode de réalisation de l'invention ;
- la figure 3, une courbe qui représente l'évolution de l'anisotropie magnétique effective $K^{eff}$ dans une multicouche selon un mode de réalisation de l'invention et une multicouche de l'art antérieur, les multicouches comprenant une couche de cobalt, en fonction de l'épaisseur de la couche de cobalt ;
- la figure 4, une courbe représentant l'évolution de l'anisotropie magnétique effective $K^{eff}$ en fonction de l'épaisseur de la couche de cobalt dans une multicouche de l'art antérieur et la multicouche de la figure 2 ;
- la figure 5, une courbe représentant l'évolution de l'aimantation à saturation Ms dans la multicouche de la figure 2 et dans une multicouche de l'art antérieur en fonction de l'épaisseur de la couche de cobalt ;
- la figure 6, une courbe représentant l'évolution de l'anisotropie magnétique effective $K^{eff}$ dans la multicouche de la figure 2 et dans une multicouche selon l'art antérieur en fonction de la température de recuit de ces multicouches ;
- la figure 7a, une vue en coupe d'une multicouche selon un mode de réalisation de l'invention ;
- la figure 7b, une vue en coupe d'une multicouche selon l'art antérieur ;
- les figures 8a à 8d, des cycles d'hystérésis mesurés par effet Kerr polaire dans des multicouches de l'art antérieur ;
- les figures 8e à 8h, des cycles d'hystérésis mesurés par effet Kerr polaire dans des multicouches selon différents modes de réalisation de l'invention ;
- la figure 9, une courbe représentant l'évolution de l'aimantation à saturation à la température T sur l'aimantation à saturation à 25°C de multicouches selon un mode de réalisation de l'invention en fonction de la température;

- la figure 10a, des cycles d'hystérésis mesurés par effet Kerr polaire dans une multicouche selon un mode de réalisation de l'invention à différentes températures ;
- la figure 10b, des cycles d'hystérésis mesurés par effet Kerr polaire dans une multicouche selon un autre mode de réalisation de l'invention à différentes températures ;
- la figure 11, une vue en coupe d'un point mémoire selon un mode de réalisation de l'invention.

Pour plus de clarté, les éléments identiques ou similaires sont repérés par des signes de référence identiques sur l'ensemble des figures.

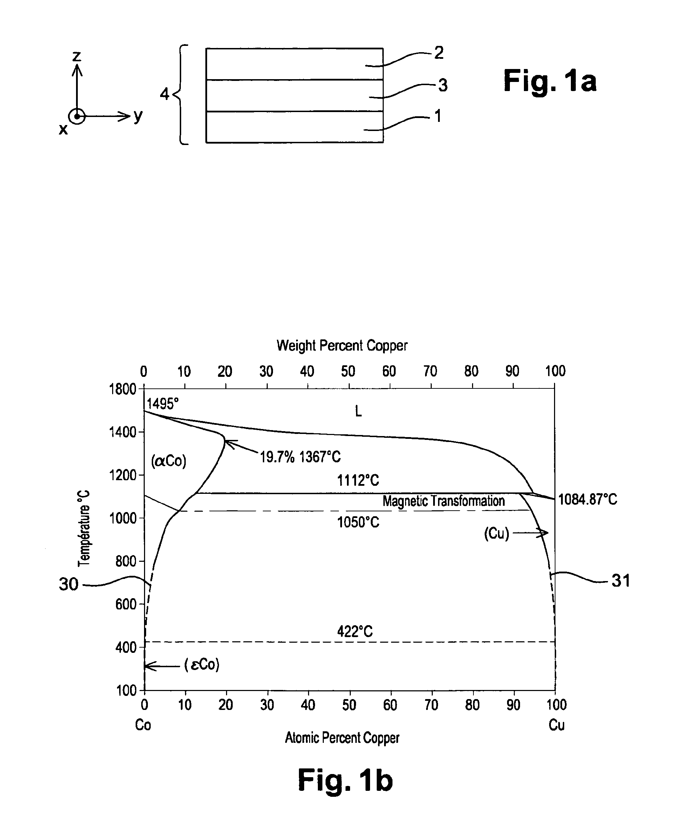

La figure 1a représente un empilement 4 selon un mode de réalisation de l'invention. Cet empilement 4 comporte une première couche 1 réalisée dans un matériau magnétique. Cette première couche 1 est de préférence constituée de cobalt, mais elle pourrait également être constituée de fer, de nickel, ou d'un alliage de ces matériaux.

L'empilement 4 comporte également une deuxième couche 2 réalisée dans un matériau non magnétique. La deuxième couche 2 est de préférence constituée de platine, mais elle pourrait également être constituée de palladium, d'or ou d'un matériau métallique donnant une anisotropie perpendiculaire interfaciale quand il forme une interface commune avec le matériau de la première couche 1. Des exemples de tels matériaux se trouvent dans les publications de F.J.A. den Broeder, W. Hoving, and P.J.H. Bloemen, "Magnetic anisotropy of multilayers", J. Magn. Magn. Mater. 93, 562-570 (1991) et de M.T. Johnson, P.J.H. Bloemen, F.J.A. den Broeder, and J.J. de Vries, "Magnetic anisotropy in metallic multilayers", Rep. Prog. Phys. 59, 1409-1458 (1996).

La première couche 1 présente de préférence une épaisseur comprise entre 0.2 nm et 1 nm. Plus précisément, lorsque la première couche 1 est réalisée en cobalt, elle présente de préférence une épaisseur supérieure à 0.2nm de façon à ce qu'elle forme un film continu. Lorsque la première couche 1 est réalisée en fer, elle présente de préférence une épaisseur supérieure à 0.2nm de façon à former un film continu. Lorsque la première couche 1 est réalisée en nickel, elle présente de préférence une épaisseur supérieure à 0.3nm de façon à former un film continu.

Selon un mode de réalisation non limitatif, la deuxième couche 2 présente une épaisseur supérieure à 0.2nm. En effet, en dessous de 0.2nm, la deuxième couche ne permet pas de couvrir entièrement les couches inférieures.

L'empilement 4 comporte également une troisième couche 3 qui est insérée entre la première couche 1 et la deuxième couche 2. Plus précisément, la troisième couche 3 est déposée directement sur la première couche 1, et la deuxième couche 2 est déposée directement sur la troisième couche 3.

Dans ce document, les couches peuvent être déposées par pulvérisation cathodique, évaporation, ou toute autre méthode de dépôt physique par phase vapeur.

La troisième couche 3 est réalisée dans un matériau métallique présentant une faible miscibilité avec la première couche 1, c'est-à-dire une miscibilité inférieure à 10%.

Ce matériau métallique peut par exemple être du cuivre, de l'argent, du magnésium, de l'aluminium. Ces matériaux présentent un coefficient de diffusion très faible dans le matériau qui constitue la première couche 1 de sorte qu'ils servent de barrière de diffusion entre la première et la deuxième couche.

A titre d'exemple, la figure 1b représente le diagramme de phase de l'alliage binaire Co-Cu. La faible miscibilité du cuivre dans le cobalt apparait sur ce diagramme de phase par la présence des deux branches 30 et 31 représentant la concentration de cuivre dans le cobalt. Le fait que ces deux branches 30, 31 soient quasiment tangentes à l'axe vertical si on extrapole vers la température ambiante montre que l'on peut introduire extrêmement peu de cuivre dans le cobalt de façon homogène : ici moins de 1% à température ambiante. De même on peut introduire extrêmement peu de cobalt dans le cuivre de façon homogène. Ceci signifie que si on cherche à mélanger beaucoup de cuivre dans le cobalt, le cuivre va essentiellement précipiter sous la forme de petites particules ou filaments de cuivre dispersés dans la matrice de cobalt mais ne va pas se mélanger de façon homogène. On dit dans ce cas que le cuivre a une faible miscibilité dans le cobalt.

Par opposition, les alliages CoNi par exemple sont connus pour former des solutions solides sur toute la gamme de concentration de nickel dans le cobalt. On dit alors que le Ni présente une forte miscibilité avec le Cobalt.

La troisième couche 3 permet à l'empilement de présenter une forte anisotropie perpendiculaire.

Dans ce document, on dit qu'un empilement, une couche, une multicouche... présente une « anisotropie perpendiculaire » ou une « anisotropie hors du plan », lorsque cet empilement, cette couche, cette multicouche s'étend parallèlement à un plan de référence, ici le plan xy, et que cet empilement, cette couche, ou cette multicouche présente une aimantation dirigée suivant un axe perpendiculaire au plan de référence, ici l'axe z.

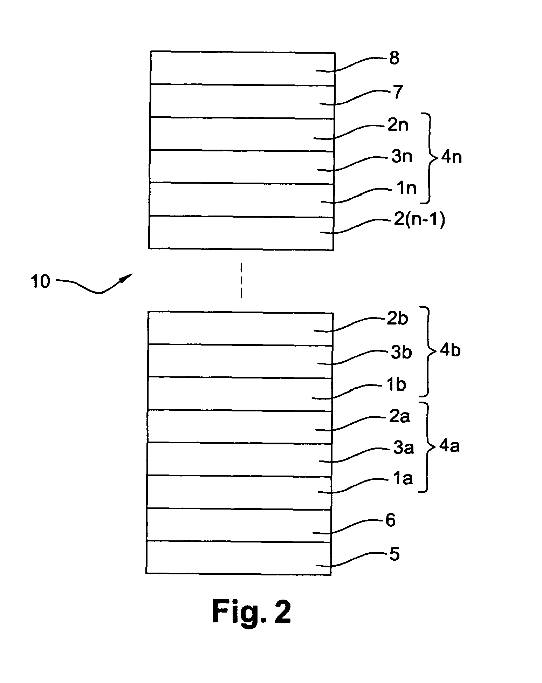

La figure 2 représente une multicouche 10 selon un mode de réalisation de l'invention.

Cette multicouche 10 peut comporter une couche tampon 5. Cette couche tampon 5 sert de base à la croissance des autres couches de la multicouche 10 et favorise l'adhérence de la multicouche sur le substrat. Cette couche tampon 5 est de préférence réalisée dans un matériau non-magnétique. Elle peut par exemple être réalisée en tantale. Elle peut par exemple présenter une épaisseur de 3 nm.

Sur la couche tampon 5, une couche en matériau non magnétique 6 peut être déposée. Cette couche en matériau non magnétique 6 permet de donner une bonne structure cristalline au reste de la multicouche. Cette couche en matériau non magnétique 6 peut par exemple être en platine et présenter une épaisseur de 5 nm.

La multicouche 10 comporte ensuite une succession de n empilements 4a, 4b, ... 4n. Chaque empilement 4a, 4b,... 4n est identique à l'empilement 4 décrit en référence à la figure 1.

Les empilements sont déposés les uns au-dessus des autres de sorte que la première couche 1 b du deuxième empilement 4b est déposée sur la deuxième couche 2a du premier empilement 4a. De même, la première couche 1 n du n-ième empilement 4n est déposée sur la deuxième couche 2(n-1) de l'empilement n-1 et ainsi de suite. En fonction du nombre de répétitions, l'épaisseur totale de la multicouche peut ainsi varier de 0.5nm à 50nm.

Dans la multicouche 10, sur chaque première couche 1a, 1 b, ...,1n en cobalt se trouve donc une troisième couche 3a, 3b" ...,3n en cuivre, en argent, en magnésium, en aluminium ou en tout autre métal faiblement miscible avec la couches 1a, 1b, ..., 1n qui est insérée entre la première couche 1a, 1 b, ..., 1 n et la deuxième couche 2a, 2b, , ...,2n. Par contre, sous chaque première couche 1a, 1b, ..., 1 n se trouve directement une couche, 2a, 2b, ...,2n-1 en platine, en palladium ou un autre métal connu pour donner une anisotropie interfaciale perpendiculaire quand il forme une interface commune avec le matériau constituant les couches 1a, 1b, ...1n, sans avoir une couche de cuivre insérée entre la première couche de l'empilement supérieur et la deuxième couche de l'empilement inférieur. Cette disposition permet d'avoir une multicouche 10 qui présente une forte anisotropie hors du plan.

La multicouche 10 peut également comporter une couche 7 ou un ensemble de couches 7 et 8 déposées au sommet de l'empilement dans un but de protection par exemple pour le protéger de l'oxydation à l'air. Ces couches de protection peuvent par exemple être en tantale 7 qui présente une épaisseur de 2 nm d'épaisseur et une couche de platine 8 qui présente également une épaisseur de 2 nm d'épaisseur.

La multicouche ainsi réalisée présente une aimantation hors du plan.

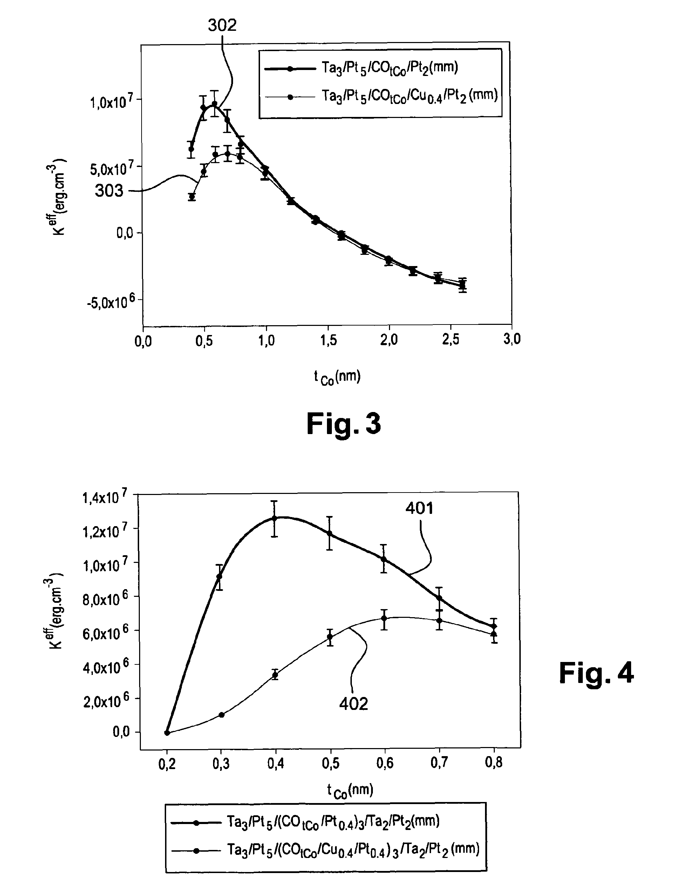

La figure 3 représente l'évolution de l'anisotropie magnétique effective dans trois multicouches comportant une couche de cobalt en fonction de l'épaisseur de la couche de cobalt.

Ainsi, la courbe 303 représente l'évolution, en fonction de l'épaisseur de la première couche en cobalt, de l'anisotropie magnétique effective $K^{eff}$ dans une multicouche de l'état de l'art antérieur qui comporte :

- une couche tampon en tantale de 3 nm d'épaisseur ;

- Une couche en platine de 5 nm d'épaisseur ;
- une première couche en cobalt dont l'épaisseur $t_{Co}$ varie ;
- une deuxième couche en platine de 2 nm d'épaisseur.

La courbe 302 représente l'évolution, en fonction de l'épaisseur de la première couche en cobalt, l'anisotropie magnétique effective $K^{eff}$ dans une multicouche selon un mode de réalisation de l'invention qui comporte :

- une couche tampon en tantale de 3 nm d'épaisseur ;
- une couche en platine de 5 nm d'épaisseur ;
- un empilement comportant :

    o une première couche en cobalt dont l'épaisseur $t_{Co}$ varie ;
    o une troisième couche en cuivre de 0.4 nm d'épaisseur ;
    o une deuxième couche en platine de 2 nm d'épaisseur.

Comme on peut le voir sur ces courbes, lorsque la première couche en cobalt présente une épaisseur $t_{Co}$ inférieure à 1 nm, la présence d'une troisième couche de cuivre sur la première couche en cobalt permet d'augmenter l'anisotropie magnétique effective $K^{eff}$, ce qui signifie que lorsque la troisième couche est présente sur la première couche, l'empilement présente une anisotropie magnétique hors du plan supérieure à celle que l'empilement présenterait en l'absence de cette troisième couche. En effet, un empilement de l'art antérieur comportant :

- une couche de tantale de 3 nm d'épaisseur ;
- une couche de platine de 5 nm d'épaisseur ;
- une première couche de cobalt de 0.5 nm d'épaisseur ;
- une deuxième couche de platine de 2 nm d'épaisseur ;

présente une aimantation sensiblement égale à 950 emu/cm³, ce qui correspond à 95.10⁴ A/m et il présente une anisotropie magnétique effective $K^{eff}$ de 4.13 Merg/cm³, ce qui correspond à 4,130.10⁵J/m³.

Si on ajoute une troisième couche en cuivre de 0.4 nm d'épaisseur entre la première et la deuxième couche de cet empilement, l'empilement présente alors une aimantation sensiblement égale à 1020 emu/cm³, ce qui correspond à 102.10⁴ A/m et il présente une anisotropie magnétique effective $K^{eff}$ de 9.18 Merg/cm³, ce qui correspond à 9,18.10⁵J/m³.

Si on ajoute une troisième couche en magnésium de 0.4 nm d'épaisseur entre la première et la deuxième couche de l'empilement de l'art antérieur décrit ci-dessus, l'empilement présente alors une aimantation sensiblement égale à 1020 emu/cm³, ce qui correspond à 102.10⁴ A/m et il présente une anisotropie effective $K^{eff}$

de 7.27 Merg/cm$^3$, ce qui correspond à 7,270.10$^5$J/m$^3$.

Ainsi, les empilements selon l'invention présentent des aimantations supérieures à celles des empilements de l'art antérieur du fait de la présence de la troisième couche entre la première et la deuxième couche ce qui évite la diffusion du matériau constitutif de la première couche dans la deuxième couche 2 et inversement. En outre, les empilements selon l'invention présentent des anisotropies magnétiques perpendiculaires supérieures à celles de l'art antérieur.

La figure 4 représente l'évolution de l'anisotropie magnétique effective K$^{eff}$ dans deux multicouches comportant plusieurs empilements identiques comportant chacun une première couche en cobalt en fonction de l'épaisseur des premières couches en cobalt.

Ainsi, la courbe 401 représente l'évolution du coefficient d'anisotropie dans une multicouche semblable à celle de la figure 2 en fonction de l'épaisseur des premières couches en cobalt.

La couche 402 représente l'évolution du coefficient d'anisotropie dans une multicouche semblable à celle de la figure 2 à la différence près que cette multicouche ne comporte pas de troisième couche sur les premières couches en cobalt.

Comme on peut le voir sur la figure 4, la multicouche qui comporte une troisième couche en cuivre sur chacune de ses premières couches en cobalt présente une anisotropie magnétique effective K$^{eff}$ plus importante que la multicouche qui ne comporte pas de troisième couche. Ainsi, la multicouche qui comporte une troisième couche en cuivre entre chaque première couche en cobalt et chaque deuxième couche en platine présente une anisotropie hors du plan d'origine interfaciale supérieure à celle de la multicouche qui ne comporte pas de troisième couche.

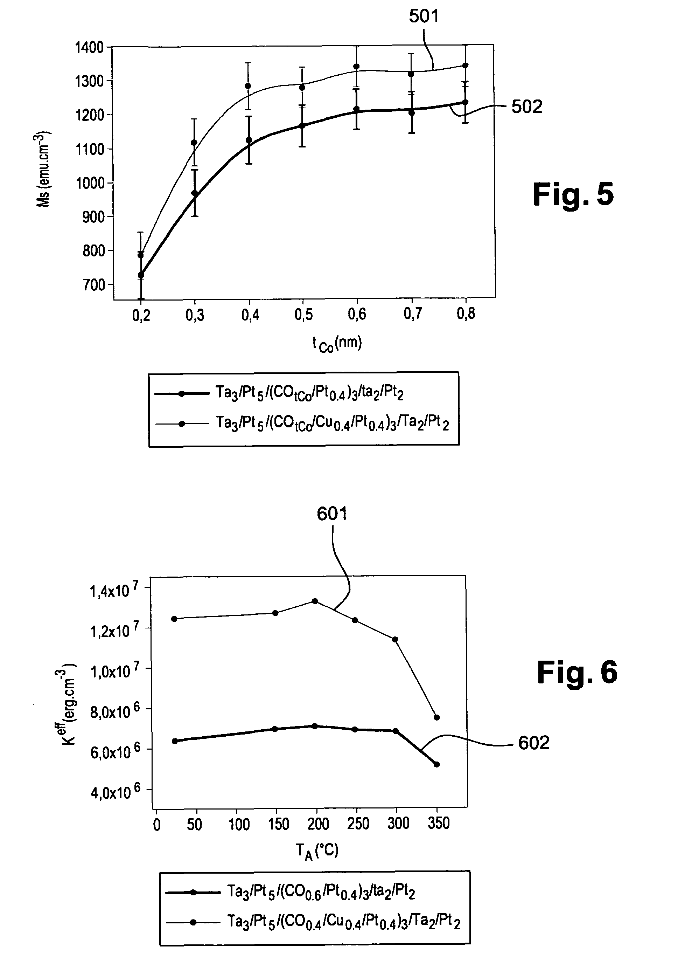

La figure 5 représente l'évolution de l'aimantation à saturation dans deux multicouches comportant une première couche de cobalt en fonction de l'épaisseur de la première couche de cobalt.

Ainsi, la courbe 501 représente l'évolution de l'aimantation à saturation dans une multicouche semblable à celle de la figure 2 en fonction de l'épaisseur des premières couches de cobalt.

La courbe 502 représente l'évolution de l'aimantation à saturation dans une multicouche semblable à celle de la figure 2 à la différence près que cette multicouche ne comporte pas de troisième couche sur les premières couches en cobalt.

Comme on peut le voir sur la figure 5, la multicouche qui comporte des troisièmes couches de cuivre sur chacune de ses premières couches de cobalt présente une aimantation à saturation plus importante que la multicouche qui ne comporte pas de troisième couche.

La figure 6 représente l'évolution de l'anisotropie magnétique effective K$^{eff}$ en fonction de la température de recuit de deux multicouches.

Plus précisément, la courbe 602 représente l'évolution de l'anisotropie magnétique effective K$^{eff}$ dans une multicouche qui comporte :

- une couche de tantale de 3 nm d'épaisseur ;
- une couche de platine de 5 nm d'épaisseur ;
- trois empilements comportant chacun:

    o une première couche de cobalt de 0.6 nm d'épaisseur ;
    o une deuxième couche de platine de 0.4 nm d'épaisseur ;

- une couche de tantale de 2 nm d'épaisseur ;
- une couche de platine de 2 nm d'épaisseur.

La courbe 601 représente l'évolution du coefficient d'anisotropie K$^{eff}$ dans une multicouche qui comporte :

- une couche de tantale de 3 nm d'épaisseur ;
- une couche de platine de 5 nm d'épaisseur ;
- trois empilements comportant chacun:

    o une première couche en cobalt de 0.4 nm d'épaisseur ;
    o une troisième couche en cuivre de 0.4 nm d'épaisseur ;
    o une deuxième couche en platine de 0.4 nm d'épaisseur ;

- une couche de tantale de 2 nm d'épaisseur ;
- une couche de platine de 2 nm d'épaisseur.

Comme on peut le voir sur ces courbes, quelle que soit la température de recuit T$_A$ comprise entre 0 et 350°C à laquelle les multicouches des courbes 601 et 602 sont recuites, la multicouche de la courbe 601 qui comporte une troisième couche en cuivre sur chaque première couche en cobalt présente une anisotropie magnétique effective supérieure à celle de la multicouche de la courbe 602 qui ne comporte pas de troisième couche.

Cette caractéristique est particulièrement intéressante car ainsi, les multicouches selon l'invention peuvent être utilisées dans des points mémoires présentant des barrières tunnel, notamment en oxyde de magnésium ou d'aluminium, sans que le recuit du point mémoire ne détruise l'anisotropie perpendiculaire de la multicouche.

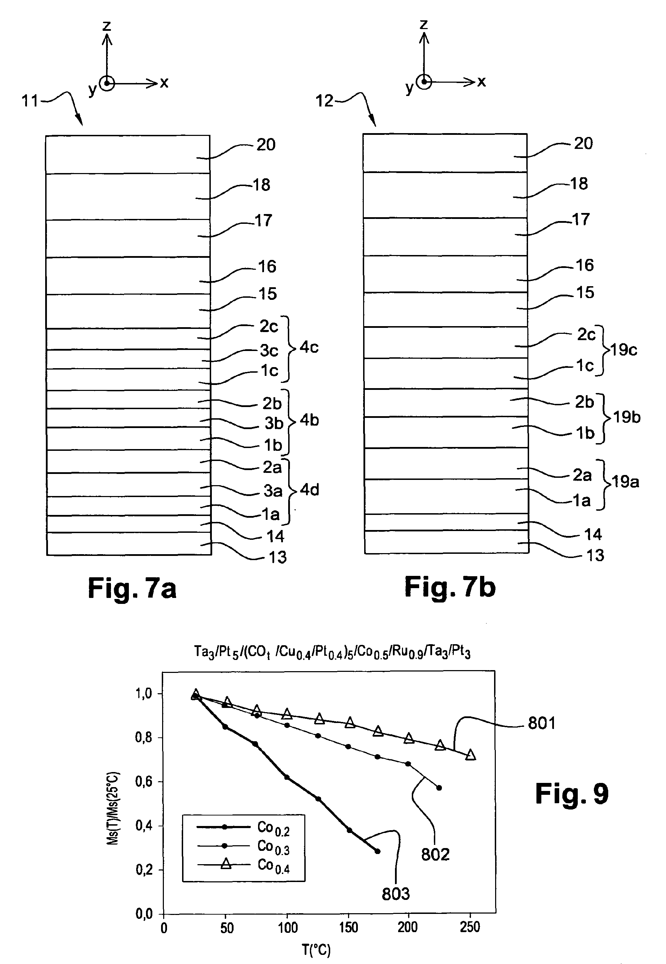

La figure 7a représente une multicouche 11 selon un mode de réalisation de l'invention. Cette multicouche 11 comporte :

- une couche de tantale 13 de 3 nm d'épaisseur ;
- une couche de platine 14 de 5 nm d'épaisseur ;
- trois empilements 4a, 4b, 4c comportant chacun :

    o une première couche en cobalt de 0.3 nm d'épaisseur ;

    o une troisième couche en cuivre de 0.4 nm d'épaisseur ;

    o une deuxième couche en platine de 0.4 nm d'épaisseur ;

- une couche additionnelle 15 en alliage Cobalt-Fer-Bore d'une épaisseur $t_{CoFeB}$ ;
- une couche en oxyde d'aluminium 16 de 0.55 nm d'épaisseur ;
- une couche en tantale 17 de 2 nm d'épaisseur ;
- une couche en platine 18 de 2 nm d'épaisseur.

La figure 7b représente une multicouche 12 de composition identique à celle de la figure 7a à l'exception du fait que les empilements ne comportent pas de troisième couche sur chaque première couche en cuivre. Plus précisément, la multicouche 12 comporte :

- une couche de tantale 13 de 3 nm d'épaisseur ;
- une couche de platine 14 de 5 nm d'épaisseur ;
- trois empilements 19a, 19b, 19c comportant chacun :

    o une première couche en cobalt de 0.3 nm d'épaisseur ;

    o une deuxième couche en platine de 0.4 nm d'épaisseur ;

- une couche additionnelle 15 en alliage Cobalt-Fer-Bore d'une épaisseur $t_{CoFeB}$ ;
- une couche en oxyde d'aluminium 16 de 0.55 nm d'épaisseur ;
- une couche en tantale 17 de 2 nm d'épaisseur ;
- une couche en platine 18 de 2 nm d'épaisseur.

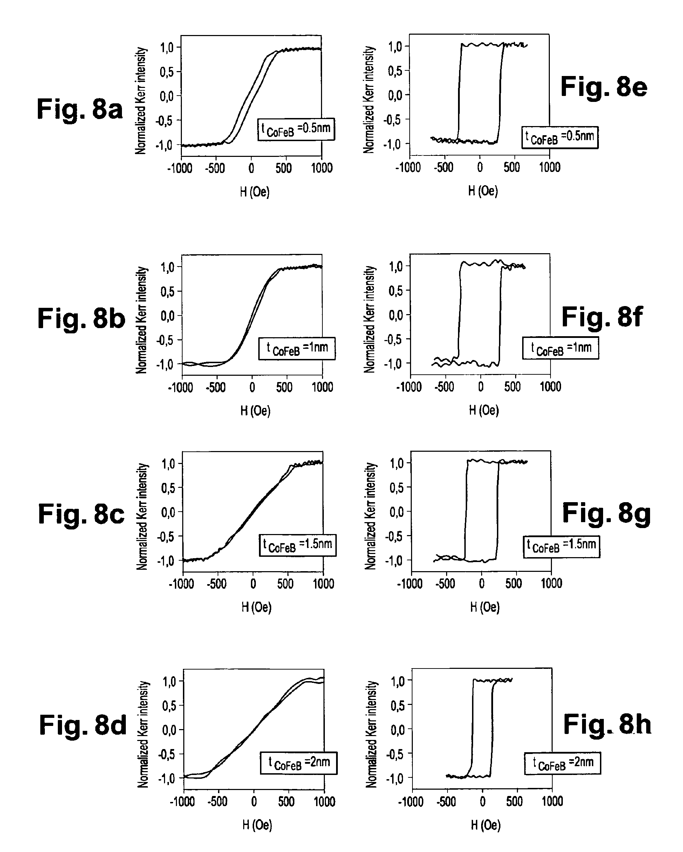

La figure 8a représente un cycle d'hystérésis mesuré par effet Kerr polaire pour la multicouche 12 de la figure 7b lorsque la couche additionnelle 15 présente une épaisseur de 0.5 nm.

La figure 8b représente un cycle d'hystérésis mesuré par effet Kerr polaire pour la multicouche 12 de la figure 7b lorsque la couche additionnelle 15 présente une épaisseur de 1 nm.

La figure 8c représente un cycle d'hystérésis mesuré par effet Kerr polaire pour la multicouche 12 de la figure 7b lorsque la couche additionnelle 15 présente une épaisseur de 1.5 nm.

La figure 8d représente un cycle d'hystérésis mesuré par effet Kerr polaire pour la multicouche 12 de la figure 7b lorsque la couche additionnelle 15 présente une épaisseur de 2 nm.

La figure 8e représente un cycle d'hystérésis mesuré par effet Kerr polaire pour la multicouche 11 de la figure 7a lorsque la couche additionnelle 15 présente une épaisseur de 0.5 nm.

La figure 8f représente un cycle d'hystérésis mesuré par effet Kerr polaire pour la multicouche 11 de la figure 7a lorsque la couche additionnelle 15 présente une épaisseur de 1 nm.

La figure 8g représente un cycle d'hystérésis mesuré par effet Kerr polaire pour la multicouche 11 de la figure 7a lorsque la couche additionnelle 15 présente une épaisseur de 1.5 nm.

La figure 8h représente un cycle d'hystérésis mesuré par effet Kerr polaire pour la multicouche 11 de la figure 7a lorsque la couche additionnelle 15 présente une épaisseur de 2 nm.

Ces cycles d'hystérésis ont été obtenus par effet Kerr polaire, en appliquant un champ magnétique perpendiculairement au plan des couches. Le protocole expérimental permettant d'obtenir ces cycles d'hystérésis par effet Kerr polaire est connu de l'art antérieur et il est par exemple décrit dans les livres intitulés « Magnétisme, Fondements (Tome I) » et « Magnétisme, Matériaux et applications (Tome 2) » édités par E. Du Tremolet de Lacheisserie, Grenoble Sciences. Ces mesures ont été effectuées avec un laser hélium-néon de longueur d'onde de 632 nanomètres et rectilignement polarisé.

Les figures 8e à 8f montrent que la présence d'une troisième couche de cuivre 3 sur la première couche de cobalt 1 permet de conférer à la multicouche 11 une aimantation perpendiculaire au plan de la multicouche dont l'anisotropie effective est suffisante pour « tirer » hors du plan l'aimantation de la couche additionnelle 15. En effet, lorsque les empilements 4a à 4c comportent une troisième couche en cuivre, en magnésium, ou tout autre métal à faible miscibilité dans la couche 1, ils présentent une anisotropie hors du plan plus élevée, de sorte qu'ils tirent l'aimantation de la couche additionnelle hors du plan, même lorsque la couche additionnelle 15 présente une épaisseur importante pouvant atteindre des valeurs de l'ordre de 2 nm.

Par contre, les figures 8a à 8d montrent qu'en l'absence de troisième couche 3 dans la multicouche 12, la multicouche présente une aimantation dans le plan de la couche. En effet, dans ce cas l'anisotropie des empilements 19a à 19c n'est pas suffisante pour « tirer » l'aimantation de la couche additionnelle hors du plan de la couche additionnelle 15.

Ainsi, la présence de la troisième couche dans les empilements permet de rendre l'aimantation de la multicouche perpendiculaire au plan de la multicouche alors que sans troisième couche, la multicouche présenterait une aimantation parallèle au plan de la multicouche.

La figure 9 représente l'évolution de l'aimantation dans des multicouches en fonction de la température de ces multicouches.

Plus précisément, les courbes 801, 802, 803 représentent chacune l'évolution, en fonction de la température T, du rapport de l'aimantation à saturation Ms(T) d'une multicouche à la température T sur l'aimantation à saturation Ms(25°C) de cette même multicouche à 25°C.

Les multicouches utilisées pour les courbes 801, 802 et 803 présentent la composition suivante :

- une couche de tantale de 3 nm d'épaisseur ;
- une couche de platine de 5 nm d'épaisseur ;
- cinq empilements comportant chacun:

  o une première couche en cobalt d'épaisseur $t_{Co}$ ;
  o une troisième couche en cuivre d'épaisseur 0.4 nm ;
  o une deuxième couche en platine de 0.4 nm d'épaisseur ;

- une couche de cobalt de 0.5 nm d'épaisseur ;
- une couche de ruthénium de 0.9 nm d'épaisseur ;
- une couche de tantale de 2 nm d'épaisseur ;
- une couche de platine de 2 nm d'épaisseur.

La multicouche utilisée pour réaliser la courbe 801 présente des premières couches en cobalt qui présentent chacune une épaisseur $t_{Co}$=0.4 nm.

La multicouche utilisée pour réaliser la courbe 802 présente des premières couches en cobalt qui présentent chacune une épaisseur $t_{Co}$=0.3 nm.

La multicouche utilisée pour réaliser la courbe 803 présente des premières couches en cobalt qui présentent chacune une épaisseur $t_{Co}$=0.2 nm.

Ces courbes montrent que la température de Curie, c'est-à-dire la température à partir de laquelle l'aimantation spontanée de la multicouche devient nulle, diminue lorsque l'épaisseur $t_{Co}$ de la première couche en cobalt de chaque empilement diminue. Cette diminution de la température de Curie est essentiellement liée à un effet de taille finie, en d'autres termes en une baisse de la coordination des atomes de cobalt c'est-à-dire du nombre de leurs voisins cobalt entraînant une diminution effective des interactions d'échange au sein de la couche de cobalt. C'est donc un phénomène général quelle que soit la nature de la troisième couche en contact avec la première couche. Cette température de Curie est un facteur essentiel pour contrôler la température de basculement d'anisotropie, phénomène décrit dans la publication de P.J. Jensen et al., Phys. Rev. B 42, 849 (1990).

De manière générale, pour obtenir une température de Curie sensiblement égale à 150°C, il est nécessaire d'avoir une première couche en cobalt dans chaque empilement qui présente une épaisseur $t_{Co}$ inférieure à 0.3 nm, et de préférence strictement inférieure à 0.3 nm. Or avec de telles épaisseurs de la première couche en cobalt, l'empilement ne peut conserver une anisotropie hors du plan à température ambiante qu'en présence de la troisième couche sur chaque première couche de l'empilement. La présence de la troisième couche en cuivre, magnésium ou tout autre métal présentant une faible miscibilité avec la première couche de cobalt permet donc d'avoir une multicouche présentant à la fois une anisotropie perpendiculaire à température ambiante, et une température de Curie réduite.

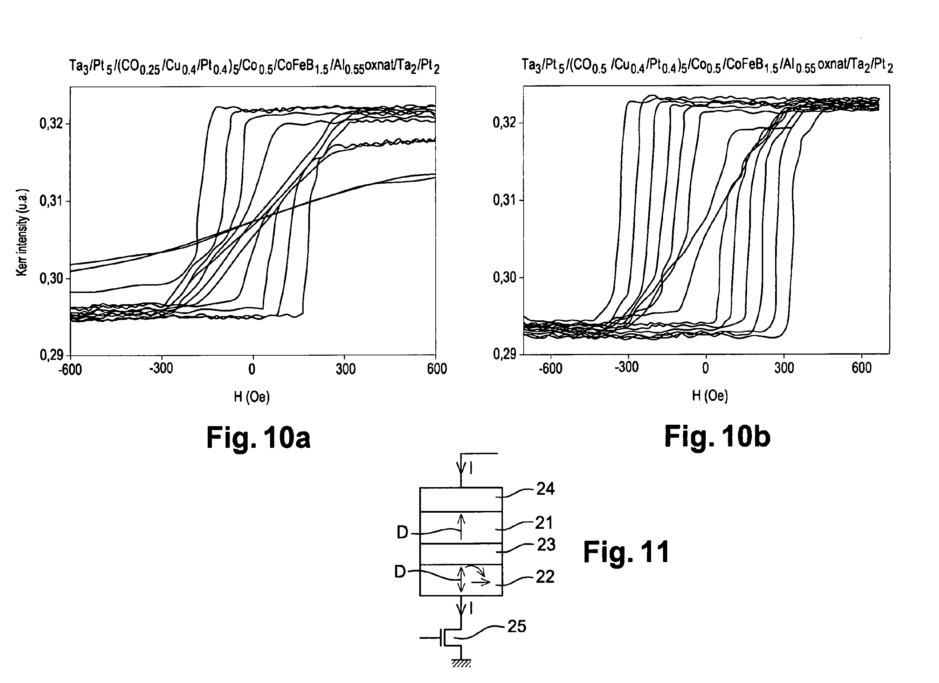

La figure 10a représente le cycle d'hystérésis mesuré par effet Kerr polaire dans une multicouche selon un mode de réalisation de l'invention comportant :

- une couche de tantale de 3 nm d'épaisseur ;
- une couche de platine de 5 nm d'épaisseur ;
- cinq empilements comportant chacun :

  o une première couche en cobalt de 0.25 nm d'épaisseur ;
  o une troisième couche en cuivre de 0.4 nm d'épaisseur ;
  o une deuxième couche en platine de 0.4 nm d'épaisseur ;

- une couche d'alliage cobalt-fer-bore de 1.5 nm d'épaisseur ;
- une couche d'oxyde d'aluminium de 0.55 nm d'épaisseur ;
- une couche de tantale de 2 nm d'épaisseur ;
- une couche de platine de 2 nm d'épaisseur.

La figure 10b représente le cycle d'hystérésis mesuré par effet Kerr polaire pour une multicouche semblable à celle de la figure 10a à l'exception du fait que la première couche en cobalt de chaque empilement présente une épaisseur de 0.3 nm au lieu de présenter une épaisseur de 0.25 nm. Pour réaliser les cycles d'hystérésis des figures 10a et 10b, un champ magnétique a été appliqué perpendiculairement au plan des couches.

Comme on peut le voir sur la figure 10a, lorsqu'on augmente la température, la direction d'aimantation de la multicouche bascule. En effet, lorsque la multicouche est à température ambiante, elle présente une direction d'aimantation perpendiculaire au plan de la multicouche, quelle que soit l'épaisseur de la première couche de cobalt. Par contre, lorsque la température augmente, l'anisotropie perpendiculaire effective qui tire l'aimantation hors du plan diminue et change de signe à une certaine température. Ce changement de signe correspond au fait que l'anisotropie de forme qui tend à rabattre l'aimantation de la couche magnétique dans le plan l'emporte alors sur l'anisotropie perpendiculaire d'origine volumique ou interfaciale qui tend à tirer l'aimantation hors du plan. A cette température critique de changement de signe de l'anisotropie effective, l'aimantation de la couche magnétique se réoriente abruptement d'une direction perpendiculaire au plan en dessous de cette température à une direction dans le plan au-dessus de cette température. Sur la figure 10a, on voit que, lorsque la première couche de cobalt présente une épaisseur de 0.25 nm, la température de basculement est proche de 150°C, tandis que lorsque la première couche de cobalt présente une épaisseur de 0.3 nm, la température de basculement est supérieure à 200°C.

Or, il est particulièrement avantageux d'avoir une multicouche qui présente une faible température de basculement d'anisotropie, c'est-à-dire de l'ordre de 150°C, spécialement lorsque la multicouche est utilisée comme couche de stockage dans un point mémoire, comme on va le voir en référence à la figure 11.

La figure 11 représente un point mémoire selon un mode de réalisation de l'invention.

Ce point mémoire comporte une première multicouche magnétique dite « couche de référence » 21. La couche de référence 21 présente une direction d'aimantation perpendiculaire au plan de la couche de référence. En outre, la couche de référence présente une direction d'aimantation fixe. Pour cela, la direction d'aimantation de la couche de référence 21 peut par exemple être piégée par une couche antiferromagnétique 24 avec laquelle la couche de référence 21 est en contact. La couche de référence 21 peut être réalisée dans une multicouche selon l'invention telle que décrite précédemment.

Le point mémoire comporte également une deuxième multicouche magnétique dite « couche de stockage » 22, la couche de stockage 22 présentant une direction d'aimantation variable. A température ambiante, lorsque le point mémoire n'est pas en train d'être écrit, la direction d'aimantation de la couche de stockage peut être placée de façon à être :

- parallèle à la direction d'aimantation de la couche de référence, dans ce cas un « 0 » est écrit dans la couche de stockage, ou bien
- antiparallèle à la direction d'aimantation de la couche de référence, et dans ce cas un « 1 » est écrit dans la couche de stockage.

La couche de stockage 22 est réalisée dans une multicouche selon l'invention, qui comporte dans cet exemple les éléments suivants :

- une couche de tantale de 3 nm d'épaisseur ;
- une couche de platine de 5 nm d'épaisseur ;
- cinq empilements comportant chacun :

      o une première couche en cobalt;
      o une troisième couche en cuivre de 0.4 nm d'épaisseur ;
      o une deuxième couche en platine de 0.4 nm d'épaisseur ;

- une couche additionnelle 15 d'alliage cobalt-fer-bore de 1.5 nm d'épaisseur.

La première couche de chaque empilement peut présenter une épaisseur de 0.25 nm ou de 0.3 nm. Comme expliqué en référence aux figures 10a et 10b, lorsque la première couche de cobalt de chaque empilement présente une épaisseur de 0.25 nm, la couche de stockage 22 présente une température de basculement d'anisotropie de l'ordre de 150°C, tandis que lorsque la première couche de cobalt de chaque empilement présente une épaisseur de 0.3 nm, la couche de stockage 22 présente une température de basculement d'anisotropie supérieure à 200°C.

Le point mémoire comporte également un espaceur 23 qui sépare la couche de référence 21 et la couche de stockage 22. L'espaceur 23 forme une barrière tunnel entre la couche de référence 21 et la couche de stockage 22. L'espaceur 23 est constitué dans cet exemple d'une couche d'oxyde d'aluminium de 0.55 nm d'épaisseur.

Le point mémoire comporte également un transistor 25 qui peut être mis dans un état passant de façon à permettre le passage d'un courant d'électrons à travers le point mémoire.

Le point mémoire est de préférence écrit par transfert de spin. Ainsi, un courant d'électrons traverse le point mémoire. Lorsque ce courant d'électrons traverse la couche de référence 21 qui est magnétique, les spins des électrons vont se trouver polarisés en spin, de sorte que les électrons sortiront de cette couche de référence 21 avec un spin polarisé. Lorsque ces électrons traversent la couche de stockage 22, ils vont subir des interactions d'échange avec les spins responsables de l'aimantation de la couche de stockage 22. Si la densité de courant est suffisamment forte, ceci va provoquer une réorientation de l'aimantation de la couche de stockage et un alignement de l'aimantation de la couche de stockage 22 par transfert du moment angulaire des électrons polarisés au moment magnétique de la couche de stockage 22. Ce phénomène est connu sous le nom de transfert de spin. Ainsi, si le courant d'électrons circule de la couche de référence vers la couche de stockage, le transfert de spin va favoriser l'orientation parallèle des aimantations des couches de stockage et de référence. Par contre, si le courant d'électrons circule de la couche de stockage vers la couche de référence, c'est l'alignement antiparallèle qui est favorisé.

Par ailleurs, le couple de transfert de spin varie comme le sinus de l'angle entre la direction de polarisation en spin des électrons et l'aimantation sur laquelle ce couple est exercé. De ce fait, ce couple est augmenté lorsque les couches de stockage et de référence présentent des directions d'aimantation perpendiculaire entre elles. Or, au repos, à température ambiante, les couches de référence 21 et de stockage 22 présentent toutes les deux des directions d'aimantations perpendiculaires au plan de ces couches et par conséquent, à température ambiante, les couches de référence 21 et de stockage 22 présentent des directions d'aimantation parallèles ou antiparallèles entre elles.

Mais, lorsqu'un courant traverse le point mémoire de façon à permettre l'écriture d'une information dans la couche de stockage, ce courant provoque l'échauffement du point mémoire et en particulier l'échauffement de la couche de stockage, de sorte que la direction d'aimantation de la couche de stockage bascule pour se rapprocher d'une direction d'aimantation dans le plan de la couche de stockage. Plus la température de Curie de la couche de stockage est faible, plus la température de basculement d'anisotropie est faible, et moins le point mémoire nécessite de courant pour être écrit. Ainsi, lorsque la couche de stockage est constituée d'une multicouche comportant une première couche de cobalt dans chaque empilement de 0.25 nm d'épaisseur, le courant qui traverse le point mémoire est suffisant pour faire basculer l'aimantation de la couche de stockage de 90°, de sorte que la direction d'aimantation de la couche de stockage devient perpendiculaire à la direction d'aimantation de la couche de référence. L'effet de transfert de spin est alors maximal ce qui permet de tirer l'aimantation de la couche de stockage dans l'hémisphère « du bas » ou dans l'hémisphère « du haut » suivant le sens du courant. Puis, lorsque l'on coupe le courant, la direction d'aimantation de la couche de stockage se redresse et devient parallèle ou antiparallèle à la direction d'aimantation de la couche de référence, suivant que le courant d'électrons a orienté la direction d'aimantation de la couche de stockage parallèlement ou antiparallèlement à la direction d'aimantation de la couche de référence.

Il est donc particulièrement intéressant d'avoir une première couche dans chaque empilement qui est constituée d'une couche de cobalt de 0.25 nm d'épaisseur de manière à favoriser le transfert de spin lors de l'écriture d'une information dans la couche de stockage. Cela permet de diminuer la densité de courant nécessaire pour écrire une information dans la couche de stockage.

## Revendications

1. Empilement magnétique (4, 4a, 4b, 4n) à aimantation hors du plan, l'empilement comportant :

   - une première couche magnétique (1, 1a, 1b, 1n) constituée d'un ou plusieurs matériaux pris dans le groupe suivant : cobalt, fer et nickel et les alliages magnétiques à base de ces matériaux ;
   - une deuxième couche (2, 2a, 2b, 2n) constituée d'un matériau métallique apte à conférer à un ensemble formé par la première et la deuxième couches une anisotropie perpendiculaire d'origine interfaciale quand la deuxième couche présente une interface commune avec la première couche ;

   l'empilement (4, 4a, 4b, 4n) étant **caractérisé en ce qu'**il comporte en outre, une troisième couche (3, 3a, 3b, 3n) déposée sur la première couche (1, 1a, 1b, 1n), la deuxième couche (2, 2a, 2b, 2n) étant déposée sur la troisième couche (3, 3a, 3b, 3n), la troisième couche (3, 3a, 3b, 3n) étant constituée d'un matériau métallique présentant une miscibilité inférieure à 10% avec le matériau de la première couche.

2. Empilement selon la revendication 1, **caractérisé en ce que** la deuxième couche (2, 2a, 2b, 2n) est constituée d'un ou plusieurs matériaux pris dans le groupe suivant : platine, palladium, or, iridium, molybdène.

3. Empilement selon l'une des revendications précédentes, **caractérisé en ce que** la troisième couche (3,3a, 3b, 3n) est constituée d'un matériau pris dans le groupe suivant : cuivre, argent, magnésium, aluminium.

4. Empilement selon l'une des revendications précédentes, **caractérisé en ce que** la troisième couche (3, 3a, 3b, 3n) présente une épaisseur comprise entre 0.2nm et 1.5nm.

5. Empilement selon l'une des revendications précédentes, **caractérisé en ce que** la première couche (1, 1 a, 1 b, 1 n) présente une épaisseur inférieure ou égale à 2 nm.

6. Empilement selon l'une quelconque des revendications précédentes, **caractérisé en ce que** la première (1, 1a, 1 b, 1n) et la deuxième couches (2, 2a, 2b, 2n) présentent chacune une épaisseur supérieure à 0.2nm.

7. Multicouche (11, 12) comportant au moins un premier (4a) et un deuxième empilements (4b) selon l'une quelconque des revendications précédentes, la multicouche (11, 12) présentant une aimantation hors du plan, la première couche (1 b) du deuxième empilement (4b) étant déposée sur la deuxième couche (2a) du premier empilement (4a).

8. Multicouche selon la revendication précédente, **caractérisée en ce qu'**elle comporte en outre une couche additionnelle (15) en matériau magnétique déposée sur les empilements (4a, 4b, 4n).

9. Multicouche selon la revendication précédente, **caractérisée en ce que** la couche additionnelle (15) est réalisée dans un des matériaux suivants :

   cobalt, fer, nickel ou alliages magnétiques à base de ces matériaux.

10. Multicouche selon la revendication précédente, dans laquelle la couche additionnelle comporte en outre un ou plusieurs des éléments suivants : B, V, Cr, Zr, Hf,Pt, Pd.

11. Point mémoire comportant :

    - une première multicouche magnétique dite « couche de référence » (21) ;
    - une deuxième multicouche magnétique dite « couche de stockage » (22), la couche de stockage (22) présentant une direction d'aimantation variable ;

- un espaceur (23) qui sépare la couche de référence (21) et la couche de stockage (22) ;

**caractérisé en ce que** la couche de référence (21) et/ou la couche de stockage (22) comportent une multicouche (10, 11) selon l'une quelconque des revendications 7 à 10.

12. Mémoire magnétique à accès aléatoire comportant un point mémoire selon la revendication précédente.

**Patentansprüche**

1. Magnetische Stapelung (4, 4a, 4b, 4n) mit Magnetisierung außerhalb der Zone, wobei die Stapelung umfasst:

- eine erste magnetische Schicht (1, 1a, 1b, 1n), die aus einem oder mehreren, aus der folgenden Gruppe genommenen Materialien gebildet ist: Kobalt, Eisen und Nickel und die auf diesen Materialien basierenden magnetischen Legierungen;
- eine zweite Schicht (2, 2a, 2b, 2n), die aus einem metallischen Material gebildet ist, das in der Lage ist, einer von der ersten und der zweiten Schicht gebildeten Struktur eine lotrechte Anisotropie mit Schnittstellenursprung zu verleihen, wenn die zweite Schicht mit der ersten Schicht eine gemeinsame Schnittstelle bildet;

wobei die Stapelung (4, 4a, 4b, 4n) **dadurch gekennzeichnet ist, dass** sie darüber hinaus eine dritte Schicht (3, 3a, 3b, 3n) umfasst, die auf der ersten Schicht (1, 1a, 1b, 1n) aufgebracht ist, wobei die zweite Schicht (2, 2a, 2b, 2n) auf der dritten Schicht (3, 3a, 3b, 3n) auf gebracht ist, wobei die dritte Schicht (3, 3a, 3b, 3n) aus einem eine Vermischung von weniger als 10 % mit dem Material der ersten Schicht aufweisenden metallischen Material gebildet ist.

2. Stapelung gemäß Anspruch 1, **dadurch gekennzeichnet, dass** die zweite Schicht (2, 2a, 2b, 2n) aus einem oder mehreren, aus der folgenden Gruppe genommenen Materialien genommen ist: Platin, Palladium, Gold, Iridium, Molybdän.

3. Stapelung gemäß einem der voranstehenden Ansprüche, **dadurch gekennzeichnet, dass** die dritte Schicht (3, 3a, 3b, 3n) aus einem aus der folgenden Gruppe genommenen Material gebildet ist: Kupfer, Silber, Magnesium, Aluminium.

4. Stapelung gemäß einem der voranstehenden Ansprüche, **dadurch gekennzeichnet, dass** die dritte Schicht (3, 3a, 3b, 3n) eine zwischen 0,2 nm und 1,5 nm inbegriffene Dicke aufweist.

5. Stapelung gemäß einem der voranstehenden Ansprüche, **dadurch gekennzeichnet, dass** die erste Schicht (1, 1a, 1b, 1n) eine Dicke dünner als oder gleich 2 nm aufweist.

6. Stapelung gemäß einem der voranstehenden Ansprüche, **dadurch gekennzeichnet, dass** die erste (1, 1a, 1b, 1n) und die zweite Schicht (2, 2a, 2b, 2n) jeweils eine Dicke von mehr als 2nm aufweisen.

7. Mehrfachschicht (11, 12), umfassend wenigstens eine erste (4a) und eine zweite Stapelung (4b) gemäß einem der voranstehenden Ansprüche, wobei die Mehrfachschicht (11, 12) eine Magnetisierung außerhalb der Ebene aufweist, wobei die erste Schicht (1b) der zweiten Stapelung (4b) auf der zweiten Schicht (2a) der ersten Stapelung (4a) aufgebracht ist.

8. Mehrfachschicht gemäß dem voranstehenden Anspruch, **dadurch gekennzeichnet, dass** sie darüber hinaus eine zusätzliche Schicht (15) aus einem magnetischen, auf den Stapelungen (4a, 4b, 4n) aufgebrachten Material umfasst.

9. Mehrfachschicht gemäß dem voranstehenden Anspruch, **dadurch gekennzeichnet, dass** die zusätzliche Schicht (15) aus einem der folgenden Materialien realisiert ist: Kobalt, Eisen, Nickel oder auf diesen Materialien basierende magnetische Legierungen.

10. Mehrfachschicht gemäß dem voranstehenden Anspruch, bei der die zusätzliche Schicht darüber hinaus ein oder mehrere der folgenden Elemente umfasst: B, V, Cr, Zn, Hf, Pt, Pd.

11. Speicherpunkt, umfassend:

- eine erste, als "Referenzschicht" (21) bezeichnete magnetische Mehrfachschicht;
- eine zweite, als "Abspeicherschicht" (22) bezeichnete, magnetische Mehrfachschicht, wobei die Speicherschicht (22) eine variable Magnetisierungsrichtung aufweist;
- einen Abstandshalter (23), der die Referenzschicht (21) und die Abspeicherschicht (22) trennt;

**dadurch gekennzeichnet, dass** die Referenzschicht (21) und / oder die Abspeicherschicht (22) eine Mehrfachschicht (10, 11) gemäß Anspruch 7 bis 10 umfassen.

**12.** Magnetischer Speicher mit zufälligem Zugriff, umfassend einen Speicherpunkt gemäß dem voranstehenden Anspruch.

**Claims**

**1.** Magnetic stack (4, 4a, 4b, 4n) with out-of-plane magnetisation, the stack comprising:

- a first magnetic layer (1, 1a, 1b, 1n) comprising one or several materials taken from the following group : cobalt, iron and nickel and magnetic alloys based on these materials;
- a second layer (2, 2a, 2b, 2n) composed of metallic material capable of conferring a perpendicular interfacial anisotropy onto an assembly comprising the first and second layers, when the second layer has a common interface with the first layer;

the stack (4, 4a, 4b, 4n) being **characterised in that** it also comprises a third layer (3, 3a, 3b, 3n) deposited on the first layer (1, 1a, 1b, 1n), the second layer (2, 2a, 2b, 2n) being deposited on the third layer (3, 3a, 3b, 3n), the third layer (3, 3a, 3b, 3n) comprising a metallic material with less than 10% miscibility with the material of the first layer.

**2.** Stack according to claim 1, **characterised in that** the second layer (2, 2a, 2b, 2n) comprises one or several materials from the group composed of platinum, palladium, gold, iridium and molybdenum.

**3.** Stack according to one of the previous claims, **characterised in that** the third layer (3, 3a, 3b, 3n) comprises a material from the following group: copper, silver, magnesium, aluminium.

**4.** Stack according to one of the previous claims, **characterised in that** the thickness of the third layer (3, 3a, 3b, 3n) is between 0.2 nm and 1.5 nm.

**5.** Stack according to one of the previous claims, **characterised in that** the first layer (1, 1a, 1b, 1n) is less than or equal to 2 nm thick.

**6.** Stack according to any one of the previous claims, **characterised in that** the first (1, 1a, 1b, 1n) and the second (2, 2a, 2b, 2n) layers are each more than 0.2nm thick.

**7.** Multilayer (11, 12) comprising at least a first (4a) and a second (4b) stack according to any one of the previous claims, the multilayer (11, 12) having an out-of-plane magnetisation, the first layer (1b) of the second stack (4b) being deposited on the second layer (2a) of the first stack (4a).

**8.** Multilayer according to the previous claim, **characterised in that** it also comprises an additional layer (15) made of magnetic material deposited on the stacks (4a, 4b, 4n).

**9.** Multilayer according to the previous claim, **characterised in that** the additional layer (15) is made from one of the following materials: cobalt, iron, nickel or magnetic alloys based on these materials.

**10.** Multilayer according to the previous claim, in which the additional layer also comprises one or several of the following elements: B, V, Cr, Zr, Hf, Pt, Pd.

**11.** Memory dot comprising:

- a first magnetic multilayer called the "reference layer" (21);
- a second magnetic multilayer called the "storage layer" (22), the storage layer (22) having a variable magnetisation direction;
- a spacer (23) that separates the reference layer (21) and the storage layer (22);

**characterised in that** the reference layer (21) and/or the storage layer (22) comprise a multilayer (10, 11) according to any one of claims 7 to 10.

**12.** Magnetic random access memory comprising a memory dot according to the previous claim.

**Fig. 1a**

**Fig. 1b**

**Fig. 2**

Fig. 3

Fig. 4

Fig. 5

Fig. 6

**Fig. 7a**

**Fig. 7b**

$Ta_3/Pt_5/(CO_t/Cu_{0.4}/Pt_{0.4})_5/Co_{0.5}/Ru_{0.9}/Ta_3/Pt_3$

**Fig. 9**

**Fig. 8a**

**Fig. 8e**

**Fig. 8b**

**Fig. 8f**

**Fig. 8c**

**Fig. 8g**

**Fig. 8d**

**Fig. 8h**

$Ta_3/Pt_5/(CO_{0.25}/Cu_{0.4}/Pt_{0.4})_5/Co_{0.5}/CoFeB_{1.5}/Al_{0.55}oxnat/Ta_2/Pt_2$

**Fig. 10a**

$Ta_3/Pt_5/(CO_{0.5}/Cu_{0.4}/Pt_{0.4})_5/Co_{0.5}/CoFeB_{1.5}/Al_{0.55}oxnat/Ta_2/Pt_2$

**Fig. 10b**

**Fig. 11**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 2817999

**Littérature non-brevet citée dans la description**

- **X. LIU ; A. MORISAKO ; H. SAKURAI ; Y. SAKURAI ; M. ITOU ; A. KOIZUMI.** Perpendicular magnetic anisotropy in sputtered amorphous Tb-FeCo films. *J. Magn. Magn. Mater.,* 2007, vol. 310, 1744-1746
- **D. WATANABE ; S. MIZUKAMI ; F. WU ; M. OOGANE ; H. NAGANUMA ; Y. ANDO ; T. MIYA-ZAKI.** Interlayer exchange coupling in perpendicularly magnetized synthetic ferrimagnet structure using CoCrPt and CoFeB. *Journal of Physics: Conference Series 200, 072104,* 2010
- **F. CASOLI ; F. ALBERTINI ; L. PARETI ; S. FABBRICI ; L. NASI ; C. BOCCHI ; R. CIPRIAN.** Growth and Characterization of Epitaxial Fe-Pt Films. *IEEE Trans. Magn.,* 2007, vol. 41, 3223-3225
- **M. YOSHIKAWA ; E. KITAGAWA ; T. NAGASE ; T. DAIBOU ; M. NAGAMINE ; K. NISHIYAMA ; T. KISHI ; H. YODA.** Tunnel Magnetoresistance Over 100% in MgO-Based Magnetic Tunnel Junction Films With Perpendicular Magnetic L10-FePt Electrodes. *IEEE Trans. Magn.,* 2008, vol. 44, 2573-2576

- **K. BARMAK ; J. KIM ; L.H. LEWIS ; K.R. COFFEY ; A.J. KELLOCK ; J.-U. THIELE.** On the relationship of magnetocrystalline anisotropy and stoichiometry in epitaxial L10 CoPt (001) and FePt (001) thin films. *J. Appl. Phys,* 2005, vol. 98, 033904
- **L. E. NISTOR ; B. RODMACQ ; S. AUFFRET ; B. DIENY.** PtICo/oxide and oxidelColPt electrodes for perpendicular magnetic tunnel junctions. *Appl. Phys. Lett.,* 2009, vol. 94, 012512
- **F.J.A. DEN BROEDER ; W. HOVING ; P.J.H. BLO-EMEN.** Magnetic anisotropy of multilayers. *J. Magn. Magn. Mater.,* 1991, vol. 93, 562-570
- **DE M.T. JOHNSON ; P.J.H. BLOEMEN ; F.J.A. DEN BROEDER ; J.J. DE VRIES.** Magnetic anisot-ropy in metallic multilayers. *Rep. Prog. Phys.,* 1996, vol. 59, 1409-1458
- **M.T. JOHNSON ; P.J.H. BLOEMEN ; F.J.A. DEN BROEDER ; J.J. DE VRIES.** Magnetic anisotropy in metallic multilayers. *Rep. Prog. Phys.,* 1996, vol. 59, 1409-1458
- **P.J. JENSEN et al.** *Phys. Rev. B,* 1990, vol. 42, 849